# EUROPEAN PATENT APPLICATION

(11) **EP 4 429 431 A1**
(43) Date of publication of application: **11.09.2024**
(21) Application number: 23806168.3
(22) Date of filing: 09.11.2023
(51) Int. Cl.: H05K 9/00, H01Q 1/24, H04M 1/02, H05K 1/11

(54) **ELECTRONIC DEVICE COMPRISING STRUCTURE FOR SHIELDING PRINTED CIRCUIT BOARD INCLUDING CONNECTOR**

(30) Priority: 20.01.2023 KR 20230008823; 30.01.2023 KR 20230012053
(71) Applicant: Samsung Electronics Co., Ltd., Suwon-si, Gyeonggi-do 16677 (KR)
(72) Inventor: NAM, Daehee, Suwon-si, Gyeonggi-do 16677 (KR); KO, Myungsub, Suwon-si, Gyeonggi-do 16677 (KR); SEO, Wonho, Suwon-si, Gyeonggi-do 16677 (KR); CHOI, Dongkil, Suwon-si, Gyeonggi-do 16677 (KR)
(74) Representative: HGF
(86) International application number: PCT/KR2023/018006
(87) International publication number: WO 2024/154914

(57) **Abstract**

According to an embodiment, an electronic device includes a supporting member, an electronic component, a first printed circuit board, a first connector, a second printed circuit board including a first part disposed between the first printed circuit board and the supporting member, a second part on which the electronic component disposed, and a third part extending from the first part to the second part, a second connector disposed on the first part, a shield wall protruding from a surface of the supporting member facing the first printed circuit board and surrounding at least part of the first part, and a shielding member covering at least part of the electronic component, and a part of the shielding member is overlapped to the first printed circuit board.

## Description

### [Technical Field]

The present disclosure relates to an electronic device including a structure for shielding a printed circuit board including a connector.

### [Background Art]

An electronic device may be miniaturized to satisfy user needs. As the electronic device becomes smaller, components in the electronic device may be disposed adjacent to each other in the electronic device. As the components in the electronic device are adjacent, an electromagnetic wave emitted from a part of the components in the electronic device may be transmitted to another part of the components in the electronic device.

### [Disclosure]

### [Technical Solution]

An electronic device is provided. According to an embodiment, the electronic device may comprise a supporting member. According to an embodiment, the electronic device may comprise an electronic component disposed in the supporting member. According to an embodiment, the electronic device may comprise a first printed circuit board including a surface facing the supporting member. According to an embodiment, the electronic device may comprise a first connector disposed on the surface of the first printed circuit board. According to an embodiment, the electronic device may comprise a second printed circuit board including a first part disposed between the first printed circuit board and the supporting member, a second part on which the electronic component disposed, and a third part extending from the first part to the second part. According to an embodiment, the electronic device may comprise a second connector coupled to the first connector and disposed on the first part. According to an embodiment, the electronic device may comprise a shield wall protruding from a surface of the supporting member facing the first printed circuit board and surrounding at least part of the first part, at least part of the shield wall including conductive material. According to an embodiment, the electronic device may comprise a shielding member covering at least part of the electronic component. According to an embodiment, a part of the shielding member may overlap the first printed circuit board. The part of the shielding member may also overlap at least part of the second circuit board (for example, it may overlap at least part of the first part and/or at least part of the third part).

An electronic device is provided. According to an embodiment, the electronic device may comprise a supporting member including a conductive part exposed to the outside of the electronic device. According to an embodiment, the electronic device may comprise a first printed circuit board including a surface facing the supporting member and disposed in the supporting member. According to an embodiment, the electronic device may comprise a first connector disposed on the surface of the first printed circuit board. According to an embodiment, the electronic device may comprise a second printed circuit board including a first part disposed between the first printed circuit board and the supporting member, a second part spaced apart from the first part, and a third part extending from the first part to the second part and having flexibility. According to an embodiment, the electronic device may comprise a second connector coupled to the first connector and disposed on the first part. According to an embodiment, the electronic device may comprise an electronic component disposed on the second part, spaced apart from the first printed circuit board along a direction in which a side surface of the first part connected to the third part faces, and at least partially surrounded by the conductive part. According to an embodiment, the electronic device may comprise a wireless communication circuit electrically connected to the conductive part and configured to communicate on a designated frequency band through the conductive part. According to an embodiment, the electronic device may comprise a shield wall protruding from a surface of the supporting member facing the first printed circuit board and surrounding at least part of the first part. According to an embodiment, the electronic device may comprise a shielding member covering at least part of the electronic member. According to an embodiment, a part of the shielding member is overlapped to the first printed circuit board.

### [Description of the Drawings]

FIG. 1 is a block diagram of an electronic device in a network environment according to various embodiments.
FIG. 2 is a diagram illustrating an exemplary electronic device according to an embodiment.
FIG. 3 is an exploded perspective view of an exemplary electronic device according to an embodiment.
FIG. 4A is a top plan view of an exemplary electronic device according to an embodiment.
FIG. 4B is a cross-sectional view illustrating an example in which an exemplary electronic device is cut along A-A' of FIG. 4A, according to an embodiment.
FIG. 4C is a perspective view illustrating an exemplary electronic component according to an embodiment.
FIG. 4D is a perspective view illustrating an example in which an exemplary electronic component and a first printed circuit board are coupled to each other, according to an embodiment.
FIG. 5A is an exploded perspective view of an exemplary electronic device according to an embodiment.
FIG. 5B is a rear view of an exemplary first printed circuit board according to an embodiment.
FIG. 6A is a top view of an exemplary electronic device according to an embodiment.
FIG. 6B is a top view of an exemplary electronic device according to an embodiment.
FIG. 6C is a cross-sectional view illustrating an example in which an exemplary electronic device is cut along B-B' of FIG. 6A, according to an embodiment.

### [Mode for Invention]

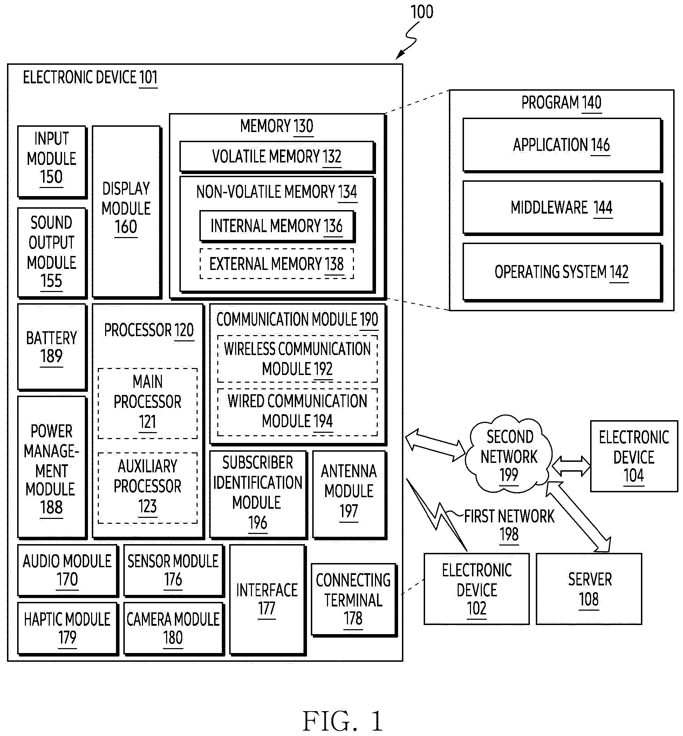

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

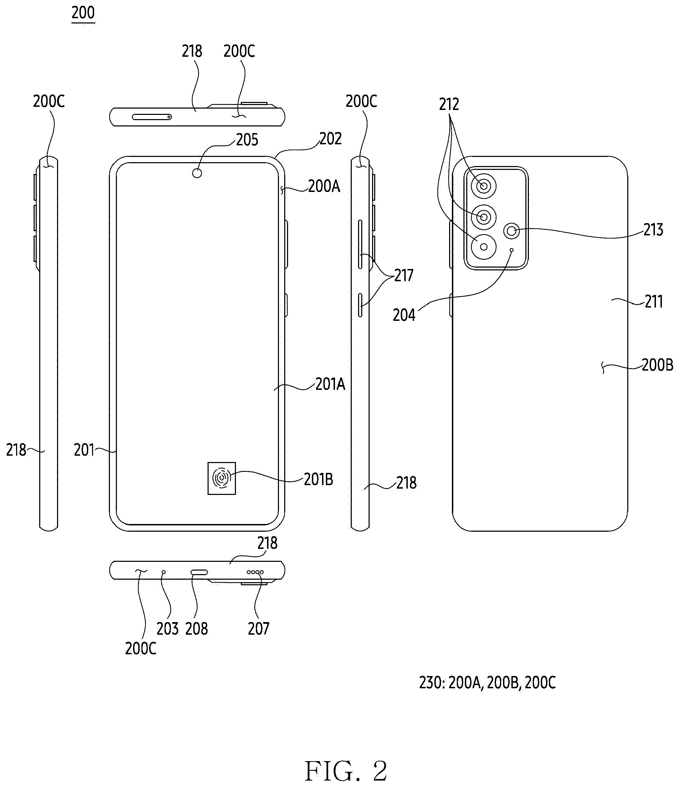

FIG. 2 is a diagram illustrating an exemplary electronic device according to an embodiment.

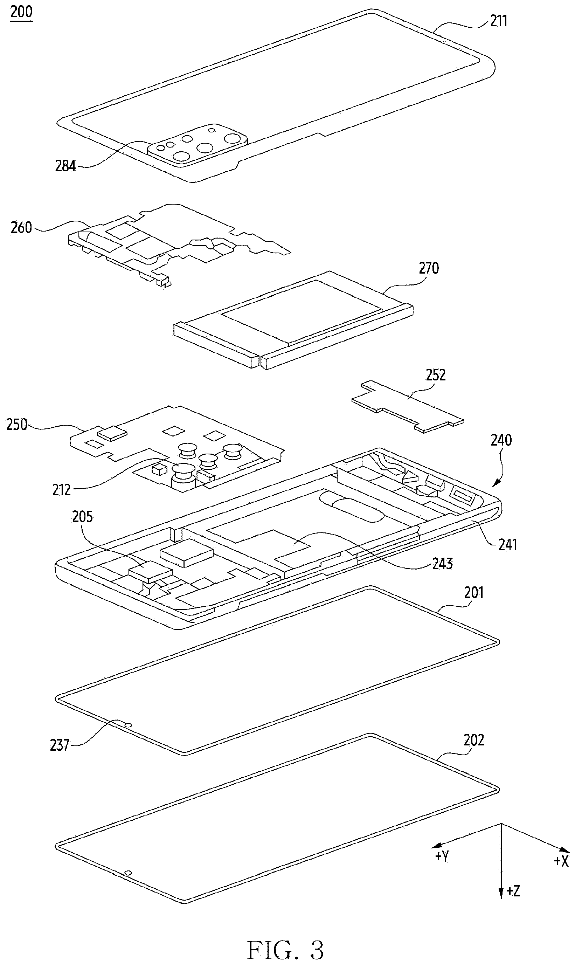

Referring to FIG. 2, according to an embodiment, an electronic device 200 (e.g., the electronic device 101 of FIG. 1) may include a housing 230 that forms an appearance of the electronic device 200. For example, the housing 230 may include a first surface (or front surface) 200A, a second surface (or rear surface) 200B, and a third surface (or side surface) 200C surrounding a space between the first surface 200A and the second surface 200B. In an embodiment, the housing 230 may refer to a structure (e.g., a frame structure 240 of FIG. 3) that forms at least a part of the first surface 200A, the second surface 200B, and/or the third surface 200C.

According to an embodiment, the electronic device 200 may include a front plate 202 that is substantially transparent. In an embodiment, the front plate 202 may form at least a part of the first surface 200A. In an embodiment, the front plate 202 may include, for example, a glass plate or a polymer plate that include various coating layers, but is not limited thereto.

According to an embodiment, the electronic device 200 may include a rear plate 211 that is substantially opaque. In an embodiment, the rear plate 211 may form at least a part of the second surface 200B. In an embodiment, the rear plate 211 may be formed by coated or colored glass, ceramic, polymer, metal (e.g., aluminum, stainless steel (STS), magnesium), or a combination of at least two of the above materials.

According to an embodiment, the electronic device 200 may include a side bezel structure (or a side member) 218 (e.g., a sidewall 241 of a frame structure 240 of FIG. 3). In an embodiment, the side bezel structure 218 may be combined with a front plate 202 and/or the rear plate 211 to form at least a part of the third surface 200C of the electronic device 200. For example, the side bezel structure 218 may form the entire third surface 200C of the electronic device 200, or for another example, may form the third surface 200C of the electronic device 200 together with the front plate 202 and/or the rear plate 211.

Unlike the illustrated embodiment, when the third surface 200C of the electronic device 200 is partially formed by the front plate 202 and/or the rear plate 211, the front plate 202 and/or the rear plate 211 may include a region that extends seamlessly by bending toward the rear plate 211 and/or the front plate 202 at a periphery thereof. For example, the extending region of the front plate 202 and/or the rear plate 211 may be located at both ends of the long edge of the electronic device 200, but are not limited by the above-described example.

In an embodiment, the side bezel structure 218 may include a metal and/or a polymer. In an embodiment, the rear plate 211 and the side bezel structure 218 may be formed integrally and may include the same material (e.g., a metal material such as aluminum), but are not limited thereto. For example, the rear plate 211 and the side bezel structure 218 may be formed as separate configurations or/or may include materials different from each other.

In an embodiment, the electronic device 200 may include at least one of a display 201, an audio module 203, 204, 207, a sensor module (not shown), a camera module 205, 212, 213, a key input device 217, a light emitting element (not shown), and/or a connector hole 208. In an embodiment, the electronic device 200 may omit at least one of the above components (e.g., a key input device 217 or a light emitting element (not shown)), or may additionally include another component.

In an embodiment, the display 201 (e.g., the display module 160 of FIG. 1) may be visually exposed through a substantial part of the front plate 202. For example, at least a part of the display 201 may be visible through the front plate 202 forming the first surface 200A. In an embodiment, the display 201 may be disposed on a rear surface of the front plate 202.

In an embodiment, the outer shape of the display 201 may be substantially the same as the outer shape of the front plate 202 adjacent to the display 201. In an embodiment, in order to expand a region where the display 201 is visually exposed, a gap between the outer periphery of the display 201 and the outer periphery of the front plate 202 may be formed to be substantially the same.

In an embodiment, the display 201 (or the first surface 200A of the electronic device 200) may include a screen display region 201A. In an embodiment, the display 201 may provide visual information to the user through the screen display region 201A. In the illustrated embodiment, when the first surface 200A is viewed from the front, the screen display region 201A is illustrated as being spaced apart from the outer periphery of the first surface 200A and positioned inside the first surface 200A, but it is not limited thereto. In an embodiment, when the first surface 200A is viewed from the front, at least a part of peripheries of the screen display region 201A may substantially match a periphery of the first surface 200A (or the front plate 202).

In an embodiment, the screen display region 201A may include a sensing region 201B configured to obtain biometric information of a user. Herein, the meaning of "the screen display region 201A includes the sensing region 201B" may be understood that at least a part of the sensing region 201B may overlap the screen display region 201A. For example, like another region of the screen display region 201A, a sensing region 201B may mean region capable of displaying visual information by the display 201, and additionally obtaining user's biometric information (e.g., fingerprints). In an embodiment, the sensing region 201B may be formed in the key input device 217.

In an embodiment, the display 201 may include a region in which the first camera module 205 (e.g., the camera module 180 of FIG. 1) is located. In an embodiment, an opening is formed in the region of the display 201, and the first camera module 205 (e.g., a punch hole camera) may be at least partially disposed in the opening to face the first surface 200A. For example, the screen display region 201A may surround at least a part of the periphery of the opening. In an embodiment, the first camera module 205 (e.g., under display camera (UDC)) may be disposed under the display 201 to overlap with the region of the display 201. For example, the display 201 may provide visual information to the user through the region, and in addition, the first camera module 205 may obtain an image corresponding to a direction facing the first surface 200A through the region of the display 201.

In an embodiment, the display 201 may be combined with or adjacent to a touch sensing circuit, a pressure sensor capable of measuring the strength (pressure) of the touch, and/or a digitizer that detects a magnetic field-type stylus pen.

In an embodiment, the audio modules 203, 204, and 207 (e.g., the audio module 170 of FIG. 1) may include microphone holes 203 and 204 and a speaker hole 207.

In an embodiment, the microphone holes 203 and 204 may include a first microphone hole 203 formed in a partial region of the third surface 200C and a second microphone hole 204 formed in a partial region of the second surface 200B. A microphone (not shown) for obtaining external sound may be disposed inside the microphone holes 203 and 204. The microphone may include a plurality of microphones to detect a direction of sound.

In an embodiment, the second microphone hole 204 formed in a partial region of the second surface 200B may be disposed adjacent to the camera modules 205, 212, and 213. For example, the second microphone hole 204 may obtain sound according to operations of the camera modules 205, 212, and 213. However, it is not limited thereto.

In an embodiment, the speaker hole 207 may include an external speaker hole 207 and a receiver hole (not shown) for a call. The external speaker hole 207 may be formed in a part of the third surface 200C of the electronic device 200. In an embodiment, the external speaker hole 207 may be implemented as one hole with the microphone hole 203. Although not shown, the receiver hole (not shown) for a call may be formed in another part of the third surface 200C. For example, the receiver hole for a call may be formed on an opposite side of the external speaker hole 207 in the third surface 200C. For example, based on the illustration of FIG. 2, an external speaker hole 207 may be formed on the third surface 200C corresponding to a lower end of the electronic device 200, and the receiver hole for a call may be formed on the third surface 200C corresponding to an upper end of the electronic device 200. However, it is not limited thereto, and in an embodiment, the receiver hole for a call may be formed at a position other than the third surface 200C. For example, the receiver hole for a call may be formed by a space spaced apart between the front plate 202 (or the display 201) and the side bezel structure 218.

In an embodiment, the electronic device 200 may include at least one speaker (not shown) configured to output sound to the outside of the housing 230 through the external speaker hole 207 and/or the receiver hole (not shown) for a call.

In an embodiment, a sensor module (not shown) (e.g., the sensor module 176 of FIG. 1) may generate an electrical signal or data value corresponding to an internal operating state of the electronic device 200 or an external environmental state. For example, the sensor module may include at least one of a proximity sensor, a HRM sensor, a fingerprint sensor, a gesture sensor, a gyro sensor, a pressure sensor, a magnetic sensor, an acceleration sensor, a grip sensor, a color sensor, an infrared (IR) sensor, a biometric sensor, a temperature sensor, a humidity sensor, or an illumination sensor.

In an embodiment, the camera module 205, 212, 213 (e.g., the camera module 180 of FIG. 1) may include a first camera module 205 disposed to face the first surface 200A of the electronic device 200, a second camera module 212 disposed to face the second surface 200B, and a flash 213.

In an embodiment, the second camera module 212 may include a plurality of cameras (e.g., a dual camera, a triple camera, or a quad camera). However, the second camera module 212 is not necessarily limited to including a plurality of cameras, and may include one camera.

In an embodiment, the first camera module 205 and the second camera module 212 may include one or more lens, image sensor, and/or image signal processor.

In an embodiment, for example, the flash 213 may include a light emitting diode or a xenon lamp. In an embodiment, two or more lenses (infrared camera, wide-angle and telephoto lens) and image sensors may be disposed on a surface of the electronic device 200.

In an embodiment, the key input device 217 (e.g., the input module 150 of FIG. 1) may be disposed on the third surface 200C of the electronic device 200. In an embodiment, the electronic device 200 may not include some or all of the key input device 217, and the key input device 217 that is not included may be implemented on the display 201 in another form such as a soft key.

In an embodiment, the connector hole 208 may be formed on the third surface 200C of the electronic device 200 to accommodate a connector of the external device. A connecting terminal (e.g., the connecting terminal 178 of FIG. 1) electrically connected to a connector of an external device may be disposed in the connector hole 208. According to an embodiment, the electronic device 200 may include an interface module (e.g., the interface 177 of FIG. 1) for processing an electrical signal transmitted and received through the connecting terminal.

In an embodiment, the electronic device 200 may include a light emitting element (not shown). For example, the light emitting element (not shown) may be disposed on the first surface 200A of the housing 230. The light emitting element (not shown) may provide state information of the electronic device 200 in the form of light. In an embodiment, the light emitting element (not shown) may provide a light source linked with an operation of the first camera module 205. For example, the light emitting element (not shown) may include an LED, an IR LED, and/or a xenon lamp.

FIG. 3 is an exploded perspective view of an exemplary electronic device according to an embodiment.

Hereinafter, repeated descriptions of configurations having the same reference numerals as those described above will be omitted.

Referring to FIG. 3, according to an embodiment, the electronic device 200 may include a frame structure 240, a first printed circuit board 250, a second printed circuit board 252, a cover plate 260, and a battery 270.

In an embodiment, the frame structure 240 may include a sidewall 241 forming the appearance of the electronic device 200 (e.g., the third surface 200C of FIG. 2) and a support part 243 extending inward from the sidewall 241. In an embodiment, the frame structure 240 may be disposed between the display 201 and the rear plate 211. In an embodiment, the side wall 241 of the frame structure 240 may surround a space between the rear plate 211 and the front plate 202 (and/or the display 201), and the support part 243 of the frame structure 240 may extend from the side wall 241 within the space.

In an embodiment, the frame structure 240 may support or accommodate other components included in the electronic device 200. For example, the display 201 may be disposed on a surface of the frame structure 240 facing in a direction (e.g., the +z direction), and the display 201 may be supported by the support part 243 of the frame structure 240. For example, the first printed circuit board 250, the second printed circuit board 252, the battery 270, and the second camera module 212 may be disposed on another surface of the frame structure 240 facing in a direction (e.g., the -z direction) opposite to the direction. The first printed circuit board 250, the second printed circuit board 252, the battery 270, and the second camera module 212 may be seated in a recess defined by the sidewall 241 and/or the support part 243 of the frame structure 240, respectively.

In an embodiment, the first printed circuit board 250, the second printed circuit board 252, and the battery 270 may be combined with the frame structure 240, respectively. For example, the first printed circuit board 250 and the second printed circuit board 252 may be fixedly disposed in the frame structure 240 through a coupling member such as a screw. For example, the battery 270 may be fixedly disposed in the frame structure 240 through an adhesive member (e.g., a double-sided tape). However, it is not limited by the above-described example.

In an embodiment, the cover plate (260) may be disposed between the first printed circuit board 250 and the rear plate 211. In an embodiment, the cover plate 260 may be disposed on the first printed circuit board 250. For example, the cover plate 260 may be disposed on a surface facing a -z direction of the first printed circuit board 250.

In an embodiment, the cover plate 260 may at least partially overlap the first printed circuit board 250 based on the z-axis. In an embodiment, the cover plate 260 may cover at least a part region of the first printed circuit board 250. Through this, the cover plate 260 may protect the first printed circuit board 250 from physical shocks or prevent a connector coupled to the first printed circuit board 250 from being separated.

In an embodiment, the cover plate 260 may be fixedly disposed to the first printed circuit board 250 through a coupling member (e.g., a screw), or may be coupled to the frame structure 240 together with the first printed circuit board 250 through the coupling member.

In an embodiment, the display 201 may be disposed between the frame structure 240 and the front plate 202. For example, the front plate 202 may be disposed on a side of the display 201 (e.g., the +z direction), and the frame structure 240 may be disposed on another side (e.g., the -z direction).

In an embodiment, the front plate 202 may be coupled to the display 201. For example, the front plate 202 and the display 201 may be bonded to each other through an optical adhesive member (e.g., optically clear adhesive (OCA) or optically clear resin (OCR)) interposed therebetween.

In an embodiment, the front plate 202 may be coupled to the frame structure 240. For example, the front plate 202 may include an outer part extending to the outside of the display 201 when viewed in the z-axis direction, and may be attached to the frame structure 240 through an adhesive member (e.g., double-sided tape) disposed between the outer part of the front plate 202 and the frame structure 240 (e.g., the side wall 241). However, it is not limited by the above-described example.

In an embodiment, the first printed circuit board 250 and/or the second printed circuit board 252 may be equipped with a processor (e.g., the processor 120 of FIG. 1), a memory (e.g., the memory 130 of FIG. 1), and/or an interface (e.g., the interface 177 of FIG. 1). For example, the processor may include one or more of a central processing unit, an application processor, a graphics processing unit, an image signal processor, a sensor hub processor, or a communication processor. For example, the memory may include a volatile memory or a nonvolatile memory. For example, the interface may include a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. In an embodiment, the first printed circuit board 250 and the second printed circuit board 252 may be operably or electrically connected to each other through a connecting member (e.g., a flexible printed circuit board).

In an embodiment, the battery 270 (e.g., the battery 189 of FIG. 1) may supply power to at least one component of the electronic device 200. For example, the battery 270 may include a rechargeable secondary battery or a fuel cell. At least a part of the battery 270 may be disposed on substantially the same plane as the first printed circuit board 250 and/or the second printed circuit board 252.

According to an embodiment, the electronic device 200 may include an antenna module (not shown) (e.g., the antenna module 197 of FIG. 1). In an embodiment, the antenna module may be disposed between the rear plate 211 and the battery 270. For example, the antenna module may include a near field communication (NFC) antenna, a wireless charging antenna, and/or a magnetic secure transmission (MST) antenna. For example, the antenna module may perform short-range communication with an external device or wirelessly transmit and receive power with the external device.

In an embodiment, the first camera module 205 (e.g., front camera) may be disposed in at least a part (e.g., the support part 243) of the frame structure 240 so that a lens may receive external light through a partial region (e.g., the camera region 237) of the front plate 202.

In an embodiment, the second camera module 212 (e.g., the rear camera) may be disposed between the frame structure 240 and the rear plate 211. In an embodiment, the second camera module 212 may be electrically connected to the first printed circuit board 250 through a connecting member (e.g., a connector). In an embodiment, the second camera module 212 may be disposed so that the lens may receive external light through the camera region 284 of the rear plate 211 of the electronic device 200.

In an embodiment, the camera region 284 may be formed on a surface (e.g., the rear surface 200B of FIG. 2) of the rear plate 211. In an embodiment, the camera region 284 may be formed to be at least partially transparent so that external light may be incident into the lens of the second camera module 212. In an embodiment, at least a part of the camera region 284 may protrude from the surface of the rear plate 211 to a predetermined height. However, it is not limited thereto, and in an embodiment, the camera region 284 may form substantially the same plane as the surface of the rear plate 211.

In an embodiment, the housing (e.g., the housing 230 of FIG. 2) of the electronic device 200 may refer to a configuration or structure that forms at least a part of the appearance of the electronic device 200. In this regard, at least a part of the front plate 202, the frame structure 240, and/or the rear plate 211 forming the appearance of the electronic device 200 may be referred to the housing 230 of the electronic device 200.

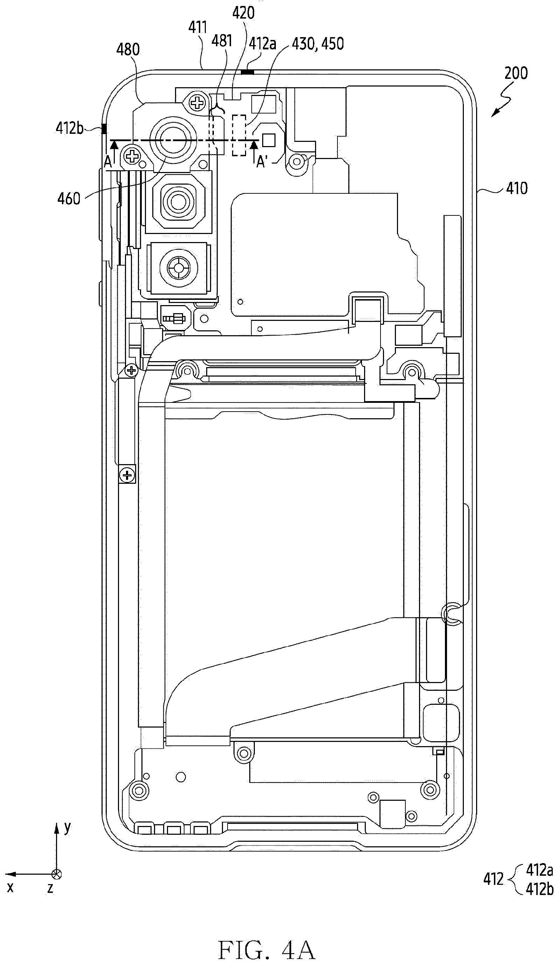

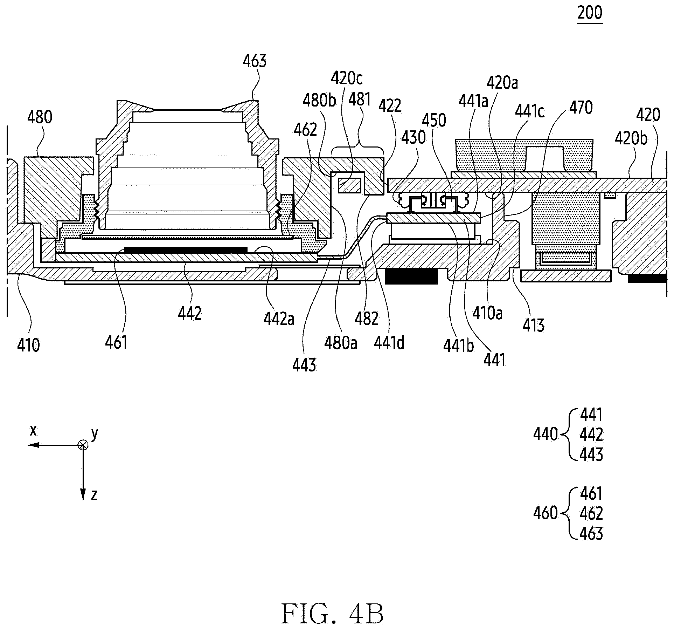

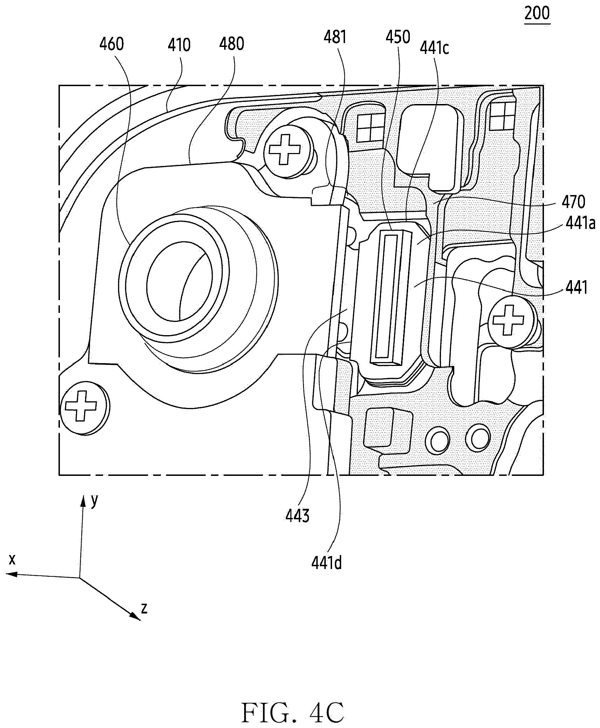

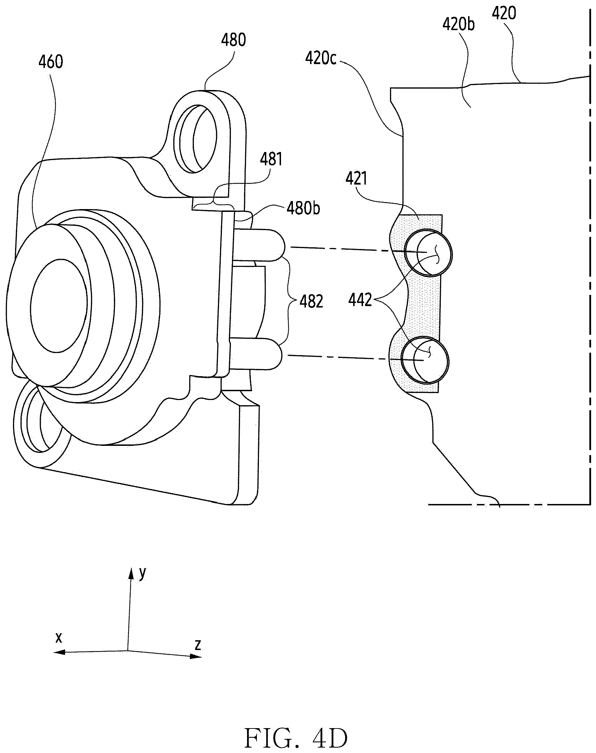

FIG. 4A is a top plan view of an exemplary electronic device according to an embodiment, FIG. 4B is a cross-sectional view illustrating an example in which an exemplary electronic device is cut along A-A' of FIG. 4A, according to an embodiment, FIG. 4C is a perspective view illustrating an exemplary electronic component according to an embodiment, and FIG. 4D is a perspective view illustrating an example in which an exemplary electronic component and a first printed circuit board are coupled to each other, according to an embodiment.

Referring to FIGS. 4A, 4B, 4C, and 4D, according to an embodiment, the electronic device 200 may include a supporting member 410 (e.g., the frame structure 240 of FIG. 3), a first printed circuit board 420 (e.g., the first printed circuit board 250 of FIG. 3) which may also be described as a nominal upper circuit board 420, a first connector 430, a third printed circuit board 440 (which may also be described as a nominal lower circuit board 440, and is the "second printed circuit board" in the language of claim 1), a second connector 450, an electronic component 460, a shield wall 470, and/or a shielding member 480.

According to an embodiment, the supporting member 410 may support components of the electronic device 200. For example, the first printed circuit board 420, the third printed circuit board 440, the electronic component 460, the shield wall 470, and/or the shielding member 480 of the electronic device 200 may be supported by the supporting member 410. The supporting member 410 may provide a space in which components of the electronic device 200 are disposed. For example, the supporting member 410 may form a space in which the first printed circuit board 420, the first connector 430, the third printed circuit board 440, the second connector 450, the electronic component 460, the shield wall 470, and/or the shielding member 480 of the electronic device 200 may be disposed.

According to an embodiment, at least a part of the supporting member 410 may include a conductive material. For example, the supporting member 410 may include a first conductive part 411, at least one non-conductive part 412, and a second conductive part 413. At least a part of the first conductive part 411 may be exposed to the outside of the electronic device 200. For example, the first conductive part 411 may define a part of the outer side surface of the supporting member 410. According to an embodiment, the electronic device 200 may include a wireless communication circuit (not shown) electrically connected to the first conductive part 411. The wireless communication circuit may be operably coupled to the first conductive part 411. The wireless communication circuit may be configured to communicate with an external electronic device distinguished from the electronic device 200 in a designated frequency band through the first conductive part 411. For example, at least a part of the first conductive part 411 may operate as an antenna radiator. For example, the designated frequency band may be referred to as a low band (e.g., a frequency band of about 1 GHz or less), but is not limited thereto. For example, the first conductive part 411 may be formed of a conductive material. The first conductive part 411 may be defined by at least one non-conductive part 412. The at least one non-conductive part 412 may separate the first conductive part 411, from another part (e.g., the second conductive part 413) of the supporting member 410 distinguished from the first conductive part 411. For example, the at least one non-conductive part 412 may electrically separate the first conductive part 411, from another part (e.g., the second conductive part 413) of the supporting member 410 distinguished from the first conductive part 411. According to an embodiment, at least a part of the at least one non-conductive part 412 may be exposed to the outside of the electronic device 200. For example, the at least one non-conductive part 412 may define another part of the outer side surface of the electronic device 200. For example, the at least one non-conductive part 412 may include a first non-conductive part 412a and a second non-conductive part 412b exposed to the outside of the electronic device 200. When the electronic device 200 is viewed from the outside, the first conductive part 411 may be disposed between the first non-conductive part 412a and the second non-conductive part 412b. For example, the at least one non-conductive part 412 may be formed by a non-conductive material. The second conductive part 413 may be electrically disconnected from the first conductive part 411. The second conductive part 413 may define an electrical ground of the supporting member 410. For example, the second conductive part 413 may be formed by a conductive material.

According to an embodiment, the first printed circuit board 420 may establish an electrical connection between electronic components in the electronic device 200. For example, the first printed circuit board 420 may form an electrical connection between electronic components disposed on the first printed circuit board 420. For example, the first printed circuit board 420 may form an electrical connection between at least one electronic component disposed on the first printed circuit board 420 and at least one electronic component disposed outside the first printed circuit board 420. For example, the first printed circuit board 420 may include at least one signal layer (not shown) for transmitting a signal transmitted/received between electronic components. For example, the first printed circuit board 420 may include at least one ground layer (not shown) that defines an electrical ground of the first printed circuit board 420. The at least one ground layer of the first printed circuit board 420 may be electrically separated (or disconnected) from at least one signal layer of the first printed circuit board 420. The first printed circuit board 420 may support electronic components in the electronic device 200. For example, the first printed circuit board 420 may support a processor (e.g., the processor 120 of FIG. 1). For example, in case that the processor 120 is disposed on the first printed circuit board 420, the first printed circuit board 420 may be referred to as a main printed circuit board.

According to an embodiment, the first printed circuit board 420 may be disposed in the supporting member 410. The first printed circuit board 420 may be surrounded by the supporting member 410. The first printed circuit board 420 may be surrounded by the supporting member 410. A surface 420a of the first printed circuit board 420 may face the supporting member 410. For example, the surface 420a of the first printed circuit board 420 may face a surface 410a of the supporting member 410. For example, a direction (e.g., +z direction) in which the surface 420a of the first printed circuit board 420 faces may be opposite to a direction (e.g., -z direction) in which the surface 410a of the supporting member 410 faces. For example, the surface 420a of the first printed circuit board 420 may be spaced apart from the surface 410a of the supporting member 410 along a direction (e.g., -z direction) in which the surface 410a of the supporting member 410 faces. According to an embodiment, another surface 420b of the first printed circuit board 420 may be opposite to the surface 420a of the first printed circuit board 420. For example, a direction (e.g., - z direction) in which the other surface 420b of the first printed circuit board 420 faces may be opposite to a direction (e.g., +z direction) in which the surface 420a of the first printed circuit board 420 faces.

According to an embodiment, the first connector 430 may electrically connect the first printed circuit board 420 and the electronic component 460 outside the first printed circuit board 420. The first connector 430 may electrically connect the first printed circuit board 420 and the third printed circuit board 440. For example, the first connector 430 may be physically coupled to the second connector 450 to electrically connect the first printed circuit board 420 and the third printed circuit board 440. For example, the first connector 430 may include a signal line for transmitting a signal between the first printed circuit board 420 and the third printed circuit board 440. For example, the first connector 430 may be one of a socket connector and a plug connector of a board to board connector (btob connector), but is not limited thereto. According to an embodiment, the first connector 430 may be disposed on the surface 420a of the first printed circuit board 420. For example, the first connector 430 may be attached on the surface 420a of the first printed circuit board 420.

According to an embodiment, the third printed circuit board 440 may form an electrical connection between the electronic component 460 and the first printed circuit board 420. For example, the third printed circuit board 440 may be electrically connected to the first printed circuit board 420 through the first connector 430 and the second connector 450. For example, the third printed circuit board 440 may include at least one signal layer (not shown) for transmitting a signal. For example, the third printed circuit board 440 may include at least one ground layer to define an electrical ground of the third printed circuit board 440. According to an embodiment, the third printed circuit board 440 may be disposed within the supporting member 410. For example, a part of the third printed circuit board 440 may be accommodated within the supporting member 410. For example, at least a part of the third printed circuit board 440 may be wrapped by the supporting member 410. For example, at least a part of the third printed circuit board 440 may be surrounded by the supporting member 410. According to an embodiment, the third printed circuit board 440 may include a first part 441, a second part 442, or a third part 443.

According to an embodiment, the first part 441 may support the second connector 450. For example, the second connector 450 may be disposed on the first part 441. For example, the second connector 450 may be disposed a surface 441a of the first part 441a facing the surface 420a of the first printed circuit board 420. According to an embodiment, the first part 441 may be disposed between the first printed circuit board 420 and the supporting member 410. The first part 441 may be disposed on the surface 410a of the supporting member 410. For example, the first part 441 may be disposed between the surface 420a of the first printed circuit board 420 and the surface 410a of the supporting member 410. For example, the surface 441a of the first part 441 may face the surface 420a of the first printed circuit board 420. For example, another surface 441b of the first part 441 may face the surface 410a of the supporting member 410. The other surface 441b of the first part 441 may be opposite to the surface 441a of the first part 441. For example, a direction (e.g., the +z direction) in which the other surface 441b of the first part 441 faces may be opposite to a direction (e.g., the -z direction) in which the surface 441a of the first part 441 faces. The other surface 441b of the first part 441 may be spaced apart from the surface 441a of the first part 441. Side surfaces 441c of the first part 441 may connect the surface 441a of the first part 441 and the other surface 441b of the first part 441. Each of the side surfaces 441c of the first part 441 may extend from the surface 441a of the first part 441 to the other surface 441b of the first part 441. For example, each of the side surfaces 441c of the first part 441 may be substantially perpendicular to the surface 441a of the first part 441. According to an embodiment, the first part 441 may have relative rigidity compared to the third part 443, but is not limited thereto. For example, the first part 441 may have substantially the same flexibility as the third part 443. According to an embodiment, when the first part 441 is viewed along a direction (e.g., the +z direction) in which the surface 420a of the first printed circuit board 420 faces, the first part 441 may be overlapped by the first printed circuit board 420. In other words, in certain embodiments (such as shown in fig. 4B) the first printed circuit board 420 overlaps at least part of the third printed circuit board 440 beneath it; the first printed circuit board 420 may, for example, completely overlap the first part 441 and extend beyond it, so as to at least partially overlap the third part 443.

According to an embodiment, the second part 442 may support the electronic component 460. The electronic component 460 may be disposed on the second part 442. For example, the electronic component 460 may be disposed on a surface 442a of the second part 442. A direction (e.g., the -z direction) in which the surface 442a of the second part 442 faces may be substantially the same as a direction (e.g., the -z direction) in which the surface 410a of the supporting member 410 faces. According to an embodiment, the second part 442 may be disposed outside the first printed circuit board 420 (in other words, the second part 442 may be disposed outside the footprint or projection of the first printed circuit board 420 onto an x-y plane, normal to the z direction; the first printed circuit board 420 may not overlap the second part 442). For example, the second part 442 may be disposed outside the first printed circuit board 420 when viewed in a direction (e.g., in the +z direction) in which the surface 420a of the first printed circuit board 420 faces. For example, the second part 442 may not overlap the first printed circuit board 420 when viewed in a direction (e.g., +z direction) in which the surface 420a of the first printed circuit board 420 faces. According to an embodiment, the second part 442 may be separated from the first part 441. For example, the second part 442 may be spaced apart from the first part 441. For example, the second part 442 may be spaced apart from the first part 441 along a direction (e.g., +x direction) in which a first side surface 441d of the first part 441 connected to the third part 443 faces. For example, the second part 442 may be spaced apart from the first part 441 along the direction (e.g., +x direction) in which the first side surface 441d of the first part 441 faces and a direction (e.g., +z direction) in which the surface 420a of the first printed circuit board 420 faces. The first side surface 441d of the first part 441 may refer to a surface connected to the third part 443 among the side surfaces 441c of the first part 441. The first side surface 441d of the first part 441 may refer to a surface facing the electronic component 460 among the side surfaces 441c of the first part 441. According to an embodiment, the second part 442 may have relative rigidity compared to the third part 443.

According to an embodiment, the third part 443 may connect the first part 441 and the second part 442. The third part 443 may extend from the first part 441 to the second part 442. For example, the third part 443 may extend from the first side surface 441d of the first part 441 to the second part 442. According to an embodiment, the third part 443 may have flexibility compared to at least one of the first part 441 and the second part 442. For example, the third part 443 may be bent within the supporting member 410. For example, the third part 443 may be curved to have a curvature within the supporting member 410. For example, when the third part 443 has flexibility, the third part 443 may be referred to as a flexible printed circuit board (FPCB). For example, when at least one of the first part 441 and the second part 442 has relative rigidity and the third part 443 has relative flexibility, the third printed circuit board 440 may be referred to as a rigid flexible printed circuit board (RFPCB).

According to an embodiment, the second connector 450 may electrically connect the first printed circuit board 420 and the third printed circuit board 440. The second connector 450 may be coupled to the first connector 430. For example, in a state combined with the first connector 430, the second connector 450 may electrically connect the first printed circuit board 420 and the third printed circuit board 440. For example, the second connector 450 may include a signal line for transmitting a signal between the first printed circuit board 420 and the third printed circuit board 440. For example, the second connector 450 may be one of a socket connector and a plug connector of a board to board connector (btob connector), but is not limited thereto. According to an embodiment, the second connector 450 may be disposed on the third printed circuit board 440. For example, the second connector 450 may be disposed on the first part 441 of the third printed circuit board 440. For example, the second connector 450 may be attached on the first part 441 of the third printed circuit board 440.

According to an embodiment, the electronic component 460 may be configured to provide a designated function to a user. The electronic component 460 may be disposed adjacent to the first conductive part 411. For example, at least a part of the electronic component 460 may be surrounded by the first conductive part 411. For example, the electronic components 460 may be configured to obtain an image based on receiving light from the outside of the electronic device 200. For example, the electronic component 460 may include an image sensor 461, an optical filter 462, and/or a lens assembly 463. Hereinafter, the electronic component 460 is described as including a camera for obtaining an image, but it is only an example. The electronic component 460 may include another electronic component in addition to the camera.

According to an embodiment, the image sensor 461 may obtain an electrical signal for obtaining an image, based on receiving light from the lens assembly 463. According to an embodiment, the image sensor 461 may be disposed on the surface 442a of the second part 442. For example, the image sensor 461 may include a charge coupled device (CCD) or a complementary metal oxide semiconductor (CMOS).

According to an embodiment, the optical filter 462 may selectively filter light having a specific wavelength. Light filtered by the optical filter 462 may be transmitted to the image sensor 461. For example, the optical filter 462 may be an infrared filter that filters infrared rays that cause color aberration and/or degradation in resolution, but is not limited thereto. According to an embodiment, the optical filter 462 may be disposed on the image sensor 461. For example, the optical filter 462 may be disposed between the image sensor 461 and the lens assembly 463.

According to an embodiment, the lens assembly 463 may collect light emitted from a subject outside the electronic device 200. According to an embodiment, the lens assembly 463 may be movable with respect to the second part 442 by an actuator (not shown). For example, the lens assembly 463 may moves by the actuator in a direction (e.g., the +z direction or the -z direction) parallel to a direction (e.g., the -z direction) in which the surface 442a of the second part 442 faces. When the lens assembly 463 moves in the (e.g., the +z direction or the -z direction) parallel to the direction (e.g., the -z direction) in which the surface 442a of the second part 442 faces, an autofocusing function may be implemented. For example, the lens assembly 463 may move by the actuator in a direction (e.g., +x direction, -x direction, +y direction, or -y direction) parallel to the surface 442a of the second part 442. When the lens assembly 463 moves in the direction (e.g., +x direction, -x direction, +y direction, or -y direction) parallel to the surface 442a of the second part 442, an optical image stabilization (OIS) function may be implemented.

According to an embodiment, the shield wall 470 may reduce an electromagnetic wave transmitted to the first printed circuit board 420 and/or the third printed circuit board 440. For example, the shield wall 470 may reduce the electromagnetic wave transmitted to the first printed circuit board 420 and/or the third printed circuit board 440 by shielding the first connector 430. For example, the shield wall 470 may reduce the electromagnetic wave transmitted to the first printed circuit board 420 and/or the third printed circuit board 440 by shielding the second connector 450. For example, the shield wall 470 may reduce the electromagnetic wave transmitted to the first part 441 of the third printed circuit board 440 by shielding the first part 441. According to an embodiment, the shield wall 470 may be disposed in the supporting member 410. For example, the shield wall 470 may protrude from the surface 410a of the supporting member 410. For example, the shield wall 470 may extend from the surface 410a of the supporting member 410 in a direction (e.g., -z direction) in which the surface 410a of the supporting member 410 faces. For example, the shield wall 470 may be electrically connected to the supporting member 410. For example, the shield wall 470 may be electrically connected to the second conductive part 413 that defines the ground of the supporting member 410. For example, the shield wall 470 may be formed integrally with the second conductive part 413 of the supporting member 410, but is not limited thereto.

According to an embodiment, the shield wall 470 may be disposed around the first part 441 so that an electromagnetic wave toward the first part 441 are reduced. The shield wall 470 may be disposed along at least a part of the side surfaces 441c of the first part 441. For example, the shield wall 470 may surround at least a part of the first part 441. For example, the shield wall 470 may wrap at least a part of the first part 441. For example, the shield wall 470 may surround at least a part of the side surfaces 441c of the first part 441. For example, the shield wall 470 may surround the rest of the side surfaces 441c of the first part 441 except for the first side surface 441d. However, it is not limited thereto. For example, the shield wall 470 may surround the rest of the first side surface 441d and a part of the first side surface 441d, among the side surfaces 441c of the first part 441. According to an embodiment, at least a part of the first side surface 441d may directly face the shielding member 480. The at least a part of the first side surface 441d may directly face the shielding member 480 through a gap between the shielding member 480 and the first part 441. For example, the at least a part of the first side surface 441d may not face the shield wall 470. For example, since the first part 441 and the second part 442 cannot be connected to each other by the third part 443 when the first side surface 441d is surrounded by the shield wall 470, the at least a part of the first side surface 441d may not be surrounded by the shield wall 470. According to an embodiment, the shield wall 470 may support the first printed circuit board 420. For example, the shield wall 470 may be in contact with the surface 420a of the first printed circuit board 420. For example, a height of the shield wall 470 may correspond to a distance between the surface 410a of the supporting member 410 and the surface 420a of the first printed circuit board 420. For example, the height of the shield wall 470 may be substantially the same as the distance between the surface 410a of the supporting member 410 and the surface 420a of the first printed circuit board 420. For example, the height of the shield wall 470 may refer to a distance in a direction (e.g., in the +z direction) in which the surface 420a of the first printed circuit board 420 faces. However, it is not limited thereto. For example, the height of the shield wall 470 may be less than the distance between the surface 410a of the supporting member 410 and the surface 420a of the first printed circuit board 420.

According to an embodiment, the shielding member 480 may shield the electronic component 460. For example, the shielding member 480 may reduce a transmission of an electromagnetic wave from the outside of the electronic component 460 (e.g., the electromagnetic wave from the first conductive part 411) to the electronic component 460. For example, the shielding member 480 may reduce the transmission of the electromagnetic wave generated by the electronic component 460 to the outside of the electronic component 460. For example, the shielding member 480 may be electrically connected to a ground layer of the second part 442 that defines an electrical ground. For example, the shielding member 480 may include a conductive material electrically connected to the ground layer in the second part 442. For example, the shielding member 480 may be referred to as a shield can, but is not limited thereto. According to an embodiment, at least a part of the shielding member 480 may be disposed on the second part 442. For example, the shielding member 480 may wrap at least a part of the electronic component 460. For example, the shielding member 480 may surround the at least a part of the electronic component 460.

According to an embodiment, a part 481 of the shielding member 480 may be formed to overlap the first printed circuit board 420 (and/or may cover at least part of the third printed circuit board 440) so that an electromagnetic wave facing the first part 441 and/or the third part 443 are reduced. For example, the part 481 of the shielding member 480 may overlap the first printed circuit board 420 and may cover (or overlap) at least a portion (and, in certain embodiments, all) of the third part 443 of the third printed circuit board 440 when viewing the first printed circuit board 420 along a direction (e.g., +z direction) in which the surface 420a of the first printed circuit board 420 faces. For example, the part 481 of the shielding member 480 may be located on the other surface 420b of the first printed circuit board 420. According to an embodiment, the part 481 of the shielding member 480 may protrude from the side surface 480a of the shielding member 480 facing the first part 441. The part 481 of the shielding member 480 may extend in a direction (e.g., -x) in which the side surface 480a of the shielding member 480 faces, from the side surface 480a of the shielding member 480 facing the first printed circuit board 420. According to an embodiment, the part 481 of the shielding member 480 may cover at least a part of a gap between another part of the shielding member 480 (and/or the electronic component 460) and the side surface 420c of the first printed circuit board 420 facing the shielding member 480. The part 481 of the shielding member 480 may be disposed on at least a part of a gap between the side surface 420c of the first printed circuit board 420 and the shielding member 480. The side surface 420c of the first printed circuit board 420 may connect the surface 420a of the first printed circuit board 420 and the other surface 420b of the first printed circuit board 420. For example, the side surface 420c of the first printed circuit board 420 may be substantially perpendicular to the surface 420a of the first printed circuit board 420 and the other surface 420b of the first printed circuit board 420. As at least a part of the gap is covered by the part 481 of the shielding member 480, an electromagnetic wave transmitted to the first part 441 and/or the third part 443 may be reduced. For example, the part 481 of the shielding member 480 may reduce an electromagnetic wave transmitted to a boundary between the first part 441 and the third part 443. For example, the part 481 of the shielding member 480 may reduce an electromagnetic wave transmitted to the first side surface 441d of the first part 441. For example, the first side surface 441d of the first part 441 may not be wrapped by the shield wall 470 in order to secure a space connected to the third part 443. When the first side surface 441d is not wrapped by the shield wall 470, an electromagnetic wave (e.g., the electromagnetic wave from the first conductive part 411) may flow into the first part 441 through the boundary between the first part 441 and the third part 443. The performance of the electronic component 460 may be reduced by flowing the electromagnetic wave into the first part 441 and/or the third part 443. According to an embodiment, the electronic device 200 may provide a structure capable of reducing the inflow of the electromagnetic wave into the first part 441 and/or the third part 443, by the part 481 of the shielding member 480 overlapping the first printed circuit board 420 (and optionally also covering/overlapping at least part of the third printed circuit board 440). For example, as the shielding member 480 is electrically connected to at least one ground layer among the first printed circuit board 420 and/or the third printed circuit board 440, the inflow of the electromagnetic wave through a gap between the shielding member 480 (and/or electronic component 460) and the side surface 420c of the first printed circuit board 420 may be reduced. As the inflow of the electromagnetic wave through the gap is reduced, a transmission of the electromagnetic wave to the first part 441 and/or the third part 443 may be reduced.

According to an embodiment, the part 481 of the shielding member 480 may be electrically connected to the ground layer of the first printed circuit board 420. For example, the part 481 of the shielding member 480 may include a conductive material electrically connected to the ground layer of the first printed circuit board 420. As the part 481 of the shielding member 480 is electrically connected to the ground layer of the first printed circuit board 420, the shielding member 480 may be electrically connected to the ground layer of the first printed circuit board 420. According to an embodiment, the part 481 of the shielding member 480 may be electrically connected to the ground layer of the first printed circuit board 420 by contacting the first printed circuit board 420. For example, the first printed circuit board 420 may include a conductive region 421 electrically connected to the ground layer of the first printed circuit board 420. For example, the conductive region 421 may be referred to as a conductive pad. The conductive region 421 may be exposed to the other surface 420b of the first printed circuit board 420. For example, the conductive region 421 may define a step difference for the other surface 420b of the first printed circuit board 420. However, it is not limited thereto. For example, the conductive region 421 may be disposed on the other surface 420b of the first printed circuit board 420. According to an embodiment, the conductive region 421 may have a shape corresponding to the part 481 of the shielding member 480. For example, area of the conductive region 421 may correspond to area of the part 481 of the shielding member 480. According to an embodiment, the part 481 of the shielding member 480 may contact the conductive region 421. For example, the part 481 of the shielding member 480 may be disposed on the conductive region 421. For example, as the part 481 of the shielding member 480 and the conductive region 421 contact each other, the shielding member 480 may be electrically connected to the ground layer of the first printed circuit board 420.

According to an embodiment, the shielding member 480 may include at least one protrusion 482. The at least one protrusion 482 may protrude from a surface 480b of the shielding member 480 facing the first printed circuit board 420. The at least one protrusion 482 may extend in a direction (e.g., +z direction) facing the first printed circuit board 420, from the surface 480b of the shielding member 480. For example, the at least one protrusion 482 may include a conductive material electrically connected to the ground layer of the first printed circuit board 420. The at least one protrusion 482 may include a plurality of protrusions, but is not limited thereto. According to an embodiment, the first printed circuit board 420 may include at least one through-hole 422. The at least one through-hole 422 may accommodate at least one protrusion 482. The at least one through-hole 422 may penetrate at least a part of the first printed circuit board 420. A conductive material may be applied within the at least one through-hole 422. For example, a conductive material may be applied to the inner surface of the first printed circuit board 420 surrounding the at least one through-hole 422. For example, the number of the at least one through-hole 422 may correspond to the number of the at least one protrusion 482. However, it is not limited thereto. For example, the number of the at least one through-hole 422 may be different from the number of the at least one protrusion 482. According to an embodiment, the at least one protrusion 482 may be inserted into the at least one through-hole 422. As the at least one protrusion 482 is inserted into the at least one through-hole 422, the ground layer of the shielding member 480 and the first printed circuit board 420 may be electrically connected. According to an embodiment, the shielding member 480 and the first printed circuit board 420 may be physically coupled. For example, as the at least one protrusion 482 is inserted into the at least one through-hole 422, the part 481 of the shielding member 480 and the first printed circuit board 420 may be physically coupled to each other. As the first printed circuit board 420 and the shielding member 480 are physically coupled, a state in which the first connector 430 and the second connector 450 are coupled may be maintained, while the first printed circuit board 420 and the third printed circuit board 440 are disposed within the supporting member 410. For example, the third part 443 may receive force in a direction (e.g., +x direction or -x direction) parallel to a direction (e.g., +x direction) in which the first side surface 441d faces, by stress generated while the first printed circuit board 420 and the third printed circuit board 440 are disposed within the supporting member 410. When the third part 443 receives a force in a direction (e.g., +x direction or -x direction) parallel to a direction (e.g., +x direction) in which the first side surface 441d faces, the possibility that the first connector 430 and the second connector 450 are separated from each other may be increased, while the first printed circuit board 420 and the third printed circuit board 440 are disposed within the supporting member 410. According to an embodiment, since the shielding member 480 and the first printed circuit board 420 are physically coupled, the electronic device 200 may provide a structure in which the possibility that the first connector 430 and the second connector 450 are separated from each other is reduced. For example, since the at least one protrusion 482 of the shielding member 480 is inserted into the at least one through-hole 422 of the first printed circuit board 420, a state in which the first connector 430 and the second connector 450 are coupled may be maintained when the third part 443 receives a force in a direction (e.g., +x direction or -x direction) parallel to a direction (e.g., +x direction) facing the first side surface 441d.

As described above, according to an embodiment, the electronic device 200 may provide a structure that reduces the transmission of the electromagnetic wave to the first part 441 and/or the third part 443 by the shielding wall 470 surrounding at least a part of the side surfaces 441c of the first part 441 supporting the second connector 450, and the shielding member 480 overlapping the first printed circuit board 420 (and/or overlapping/covering at least part of the third printed circuit board 440). According to an embodiment, since the shielding member 480 and the first printed circuit board 420 are physically coupled to each other, the electronic device 200 may provide a structure capable of maintaining a coupling between the first connector 430 and the second connector 450.

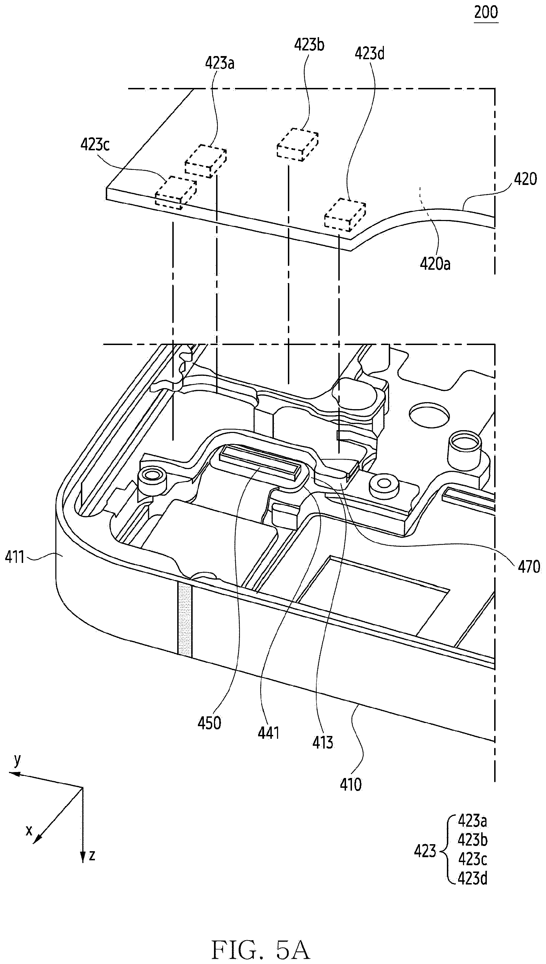

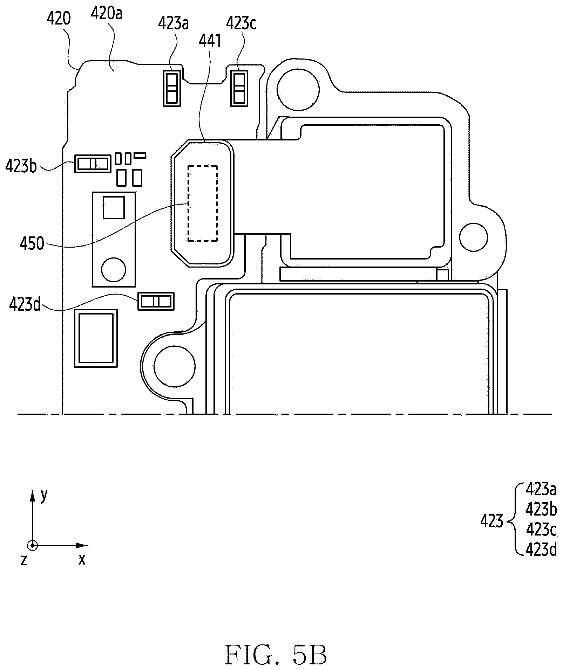

FIG. 5A is an exploded perspective view of an exemplary electronic device according to an embodiment, and FIG. 5B is a rear view of an exemplary first printed circuit board according to an embodiment.

Referring to FIG. 5A and FIG. 5B, according to an embodiment, the first printed circuit board 420 may include a plurality of contacts 423. The plurality of contacts 423 may establish an electrical connection between the first printed circuit board 420 and external components of the first printed circuit board 420. For example, the plurality of contacts 423 may electrically connect the first printed circuit board 420 and the supporting member 410. The plurality of contacts 423 may include a conductive material. For example, the plurality of contacts 423 may be referred to as a c-clip, but are not limited thereto. According to an embodiment, the plurality of contacts 423 may be disposed on the first printed circuit board 420. For example, the plurality of contacts 423 may be disposed on the surface 420a of the first printed circuit board 420. According to an embodiment, the plurality of contacts 423 may be disposed around the second connector 450. The plurality of contacts 423 may surround at least a part of the second connector 450. The plurality of contacts 423 may wrap at least a part of the second connector 450. According to an embodiment, the plurality of contacts 423 may be spaced apart from each other. According to an embodiment, the plurality of contacts 423 may include a first contact 423a, a second contact 423b, a third contact 423c, and/or a fourth contact 423d.

According to an embodiment, the first contact 423a may electrically connect a signal layer of the first printed circuit board 420 and the first conductive part 411 of the supporting member 410. For example, the first contact 423a may electrically connect a wireless communication circuit disposed on the first printed circuit board 420 and the first conductive part 411 of the supporting member 410. The wireless communication circuit may supply power to the first conductive part 411 through the first contact 423a. The first conductive part 411 may emit the electromagnetic wave to the outside of the electronic device 200 based on receiving power through the first contact 423a. According to an embodiment, the first contact 423a may be electrically disconnected from the second conductive part 413 that defines the electrical ground of the supporting member 410. The first contact 423a may be electrically disconnected from the second contact 423b, the third contact 423c, and/or the fourth contact 423d.

According to an embodiment, each of the second contact 423b, the third contact 423c, and/or the fourth contact 423d may electrically connect the ground layer of the first printed circuit board 420 and the second conductive part 413 of the supporting member 410. For example, each of the second contact 423b, the third contact 423c, and/or the fourth contact 423d may be electrically connected to the ground layer of the first printed circuit board 420. Each of the second contact 423b, the third contact 423c, and/or the fourth contact 423d may be electrically connected to the second conductive part 413 of the supporting member 410. For example, each of the second contact 423b, the third contact 423c, and/or the fourth contact 423d may contact the second conductive part 413 of the supporting member 410. As each of the second contact 423b, the third contact 423c, and/or the fourth contact 423d is electrically connected to the second conductive part 413 defining the ground of the supporting member 410, the inflow of the electromagnetic wave into the second connector 450 and the first part 441 may be reduced.

According to an embodiment, each of the second contact 423b, the third contact 423c, and/or the fourth contact 423d may surround at least a part of the second connector 450. For example, each of the second contact 423b, the third contact 423c, and/or the fourth contact 423d may be disposed along the shield wall 470. According to an embodiment, each of the second contact 423b, the third contact 423c, and/or the fourth contact 423d may be spaced apart from the second connector 450. For example, the second contact 423b may be spaced apart from the second connector 450 along a direction (e.g., -x direction) opposite to a direction (e.g., +x direction) in which the side surface 420c of the first printed circuit board 420 faces. For example, the third contact 423c may be spaced apart from the second connector 450 in a direction approaching to the first conductive part 411. For example, the fourth contact 423d may be spaced apart from the second connector 450 in a direction away from the first conductive part 411. However, a direction in which each of the second contact 423b, the third contact 423c, and/or the fourth contact 423d is spaced apart from the second connector 450 is not limited thereto.

As described above, according to an embodiment, the electronic device 200 may provide a structure capable of reducing the inflow of the electromagnetic wave toward the second connector 450 and the first part 441 by the plurality of contacts 423 disposed adjacent to the first part 441 supporting the second connector 450.

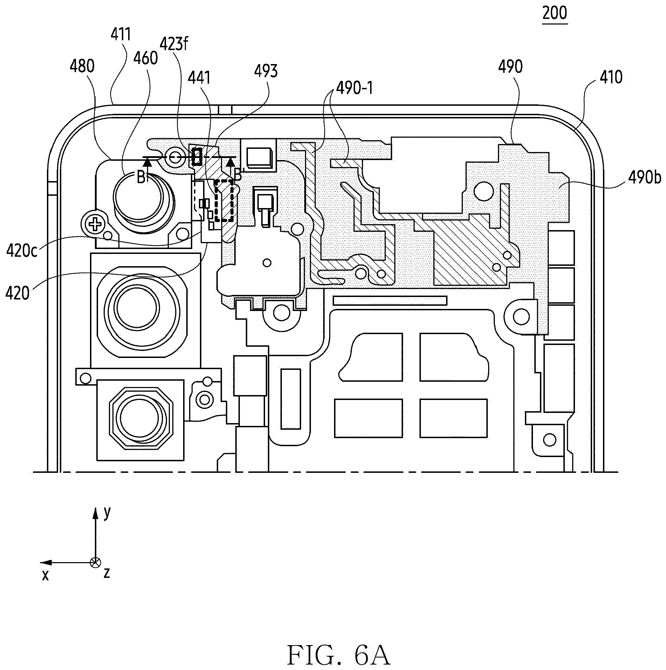

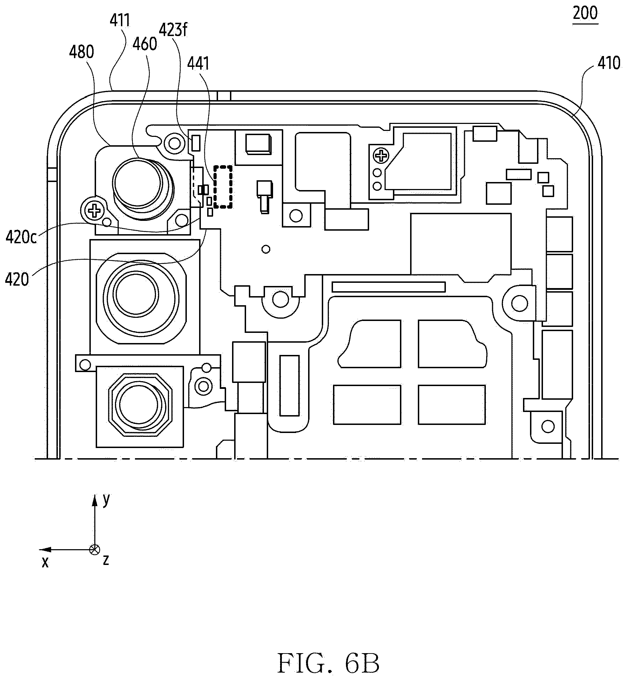

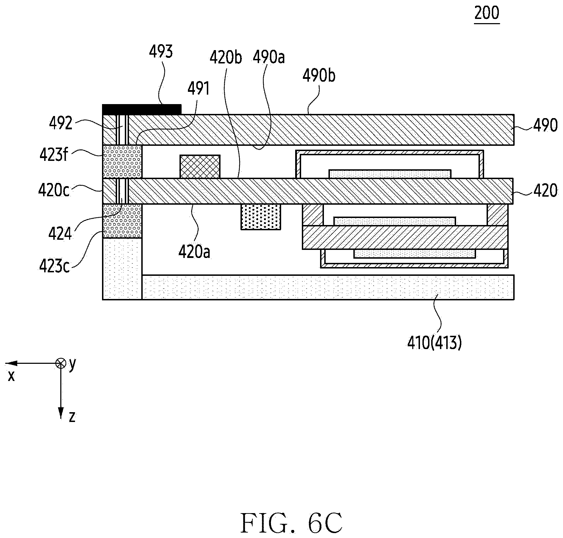

FIG. 6A is a top view of an exemplary electronic device according to an embodiment, FIG. 6B is a top view of an exemplary electronic device according to an embodiment, and FIG. 6C is a cross-sectional view illustrating an example in which an exemplary electronic device is cut along B-B' of FIG. 6A, according to an embodiment.

FIG. 6A illustrates an example of a state in which an antenna module 490 is disposed on the other surface 420b of the first printed circuit board 420, and FIG. 6B illustrates an example of a state in which the antenna module 490 is omitted.

Referring to FIGS. 6A, 6B, and 6C, according to an embodiment, the electronic device 200 may further include the antenna module 490. Through the antenna module 490, the electronic device 200 may transmit a signal to the external electronic device or receive a signal from the external electronic device. The antenna module 490 may include an antenna radiator defined as a conductor pattern formed on a substrate. For example, the antenna module 490 may include a laser direct structuring (LDS) pattern 490-1, but is not limited thereto. According to an embodiment, the antenna module 490 may be disposed on the other surface 420b of the first printed circuit board 420. For example, the antenna module 490 may be spaced apart from the other surface 420b of the first printed circuit board 420 in a direction (e.g., -z direction) in which the other surface 420b of the first printed circuit board 420 faces.

According to an embodiment, the first printed circuit board 420 may include a fifth contact 423f and/or a first conductive via 424. The fifth contact 423f may be electrically connected to the ground layer of the first printed circuit board 420. The fifth contact 423f may be disposed on the first printed circuit board 420. For example, the fifth contact 423f may be disposed on the other surface 420b of the first printed circuit board 420. The fifth contact 423f may be in contact with a part of the antenna module 490. The first conductive via 424 may electrically connect the third contact 423c and the fifth contact 423f. The first conductive via 424 may penetrate at least a part of the first printed circuit board 420. For example, the first conductive via 424 may extend from the surface 420a of the first printed circuit board 420 to the other surface 420b of the first printed circuit board 420. For example, the first conductive via 424 may be a through-hole via, but is not limited thereto. As the third contact 423c and the fifth contact 423f are electrically connected by the first conductive via 424, the fifth contact 423f may be electrically connected to the second conductive part 413 defining the ground of the supporting member 410.

According to an embodiment, the antenna module 490 may include a conductive material 491, a second conductive via 492, and/or a ground pattern 493.

According to an embodiment, the conductive material 491 may be electrically connected to the ground layer of the first printed circuit board 420 through the fifth contact 423f. The conductive material 491 may be in contact with the fifth contact 423f. The conductive material 491 may be electrically connected to the second conductive part 413 of the supporting member 410 through the third contact 423c and the fifth contact 423f. The conductive material 491 may be disposed on a surface 490a of the antenna module 490 facing the other surface 420b of the first printed circuit board 420. The conductive material 491 may be formed on the surface 490a of the antenna module 490 facing the other surface 420b of the first printed circuit board 420. The conductive material 491 may be disposed on the surface 490a of the antenna module 490. For example, a direction (e.g., +z direction) in which the surface 490a of the antenna module 490 faces may be opposite to a direction (e.g., -z direction) in which the other surface 420b of the first printed circuit board 420 faces.

According to an embodiment, the second conductive via 492 may electrically connect the conductive material 491 and the ground pattern 493. The second conductive via 492 may penetrate at least a part of the antenna module 490. For example, the second conductive via 492 may extend from the surface 490a of the antenna module 490 to the other surface 490b of the antenna module 490. The other surface 490b of the antenna module 490 may be opposite to the surface 490a of the antenna module 490. For example, a direction (e.g., -z direction) in which the other surface 490b of the antenna module 490 faces may be opposite to a direction (e.g., +z direction) in which the surface 490a of the antenna module 490 faces. For example, the second conductive via 492 may be a through-hole via, but is not limited thereto. The LDS pattern 490-1 may be disposed on the other surface 490b of the antenna module 490. For example, the LDS pattern 490-1 may be formed on the other surface 490b of the antenna module 490.

According to an embodiment, the ground pattern 493 may be electrically connected to the ground layer of the first printed circuit board 420 through the conductive material 491. For example, the ground pattern 493 may be electrically connected to the second conductive part 413 of the supporting member 410 through the third contact 423c and the fifth contact 423f. According to an embodiment, the ground pattern 493 may be disposed on the other surface 490b of the antenna module 490. For example, the ground pattern 493 may be formed on the other surface 490b of the antenna module 490. For example, the ground pattern 493 may be disposed on the other surface 490b of the antenna module 490. For example, the ground pattern 493 may be located adjacent to the other surface 490b of the antenna module 490. According to an embodiment, the ground pattern 493 may surround at least a part of the first part 441. For example, the ground pattern 493 may be disposed along the side surface 420c of the first printed circuit board 420 facing the shielding member 480. As area of a shielding structure for reducing an electromagnetic wave (e.g., the electromagnetic wave from the first conductive part 411) from the outside of the electronic component 460 is expanded by the ground pattern 493, the inflow of the electromagnetic wave into the first part 441 may be reduced. As the inflow of the electromagnetic wave toward the first part 441 is reduced, operation of the electronic component 460 may be smooth.

As described above, according to an embodiment, since a part of the antenna module 490 is electrically connected to the second conductive part 413 defining the ground, the electronic device 200 may provide a structure in which the inflow of the electromagnetic wave toward the first part 441 is reduced.

The printed circuit board disposed in the electronic device may electrically connect a part and another part among the components of the electronic device through a connector. As components in the electronic device are adjacent to each other, the printed circuit board supporting the connector may be exposed to the electromagnetic wave from components outside the printed circuit board. For example, since the electromagnetic wave emitted from an antenna of the electronic device is transmitted to a printed circuit board, it may cause noise in the part and the other part among components. The electronic device may need a shielding structure capable of reducing an electromagnetic wave transmitted to the printed circuit board supporting the connector.

An electronic device (e.g., the electronic device 200 of FIG. 2) is provided. According to an embodiment, the electronic device may comprise a supporting member (e.g., the supporting member 410 of FIG. 4A, FIG. 4B, and FIG. 4C). According to an embodiment, the electronic device may comprise an electronic component (e.g., the electronic component 460 of FIG. 4A, FIG. 4B, FIG. 4C, and FIG. 4D) disposed in the supporting member. According to an embodiment, the electronic device may comprise a first printed circuit board (e.g., the first printed circuit board 420 of FIG. 4A, FIG. 4B, and FIG. 4D) including a surface (e.g., the surface 420a of FIG. 4A and FIG. 4B) facing the supporting member. According to an embodiment, the electronic device may comprise a first connector (e.g., the first connector 430 of FIG. 4A, FIG. 4B, and FIG. 4C) disposed on the surface of the first printed circuit board. According to an embodiment, the electronic device may comprise a second printed circuit board (e.g., the third printed circuit board 440 of FIG. 4B and FIG. 4C) including a first part (e.g., the first part 441 of FIG. 4B and FIG. 4C) disposed between the first printed circuit board and the supporting member, a second part (e.g., the second part 412 of FIG. 4B) on which the electronic component disposed, and a third part (e.g., the third part 413 of FIG. 4B and FIG. 4C) extending from the first part to the second part. According to an embodiment, the electronic device may comprise a second connector (e.g., the second connector 450 of FIG. 4B and FIG. 4C) coupled to the first connector and disposed on the first part. According to an embodiment, the electronic device may comprise a shield wall (e.g., the shield wall 470 of FIG. 4B and FIG. 4C) protruding from a surface (e.g., the surface 410a of FIG. 4B) of the supporting member facing the first printed circuit board and surrounding at least part of the first part to reduce an electromagnetic wave facing at least one of the first part and the third part, at least part of the shield wall including conductive material. According to an embodiment, the electronic device may comprise a shielding member (e.g., the shielding member 480 of FIG. 4A, FIG. 4B, FIG. 4C, and FIG. 4D) covering at least part of the electronic component. According to an embodiment, a part (e.g., part 481 of FIG. 4A, FIG. 4B, FIG. 4C, and FIG. 4D) of the shielding member may overlap the first printed circuit board and may overlap/cover at least part of the second (or third, in the language used to describe fig. 4B) printed circuit board, in order to reduce the electromagnetic wave facing at least one of the first part and the third part.

According to an embodiment, the electronic device may provide a structure that reduces a transmission of an electromagnetic wave to the first printed circuit board and the second printed circuit board by a shield wall surrounding at least a part of the first part and a shielding member partially overlapping the first printed circuit board (and optionally covering at least part of the second printed circuit board below). According to an embodiment, since the electronic device is physically coupled to the shielding member and the first printed circuit board, a structure capable of stably maintaining the coupling between the first connector and the second connector may be provided.

According to an embodiment, the part of the shielding member covers a gap disposed between the shielding member (and/or electronic component 460) and a side surface (e.g., the side surface 420c of FIG. 4B) of the first printed circuit board perpendicular to the surface of the first printed circuit board.

According to an embodiment, the electronic device may provide a structure that reduces the transmission of the electromagnetic wave to the first printed circuit board and the second printed circuit board by a shielding member covering at least a part of a gap between the first printed circuit board and the shielding member (and/or electronic component 460).

According to an embodiment, the second part may be disposed outside of the first printed circuit board by being spaced apart from the first part along a direction in which the side surface (e.g., the first side surface 441d of FIG. 4B) of the first part connected to the third part faces.

According to an embodiment, since the second part does not overlap the first printed circuit board, the electronic device may provide a structure in which various components may be disposed within the electronic device.

According to an embodiment, the part of the shielding member may be disposed on another surface (e.g., the other surface 420b of FIG. 4B) of the printed circuit board opposite to the surface of the first printed circuit board.

According to an embodiment, the electronic device may provide a structure that reduces the transmission of the electromagnetic wave to the first printed circuit board and the second printed circuit board by a shielding member overlapping (e.g. partially) the first printed circuit board, and/or covering at least part of the second printed circuit board.

According to an embodiment, the part of the shielding member may be electrically connected to a ground layer of the first printed circuit board by being in contact with the first printed circuit board.

According to an embodiment, the electronic device may provide a structure that reduces the transmission of the electromagnetic wave to the first printed circuit board and the second printed circuit board by a shielding member electrically connected to the ground of the first printed circuit board.

According to an embodiment, the first printed circuit board may include a conductive region (e.g., the conductive region 421 of FIG. 4D) electrically connected to the ground layer of the first printed circuit board and exposed to the other surface of the first printed circuit board opposite to the surface of the first printed circuit board. According to an embodiment, the part of the shielding member may include a conductive material electrically connected to the ground layer of the first printed circuit board by being in contact with the conductive region.

According to an embodiment, the electronic device may provide a structure that reduces the transmission of the electromagnetic wave to the first printed circuit board and the second printed circuit board by a shielding member electrically connected to the ground of the first printed circuit board.

According to an embodiment, the shielding member may include a conductive material electrically connected a ground layer of the second part.

According to an embodiment, the electronic device may provide a structure that reduces the transmission of the electromagnetic wave to the first printed circuit board and the second printed circuit board by a shielding member electrically connected to the ground of the second part included in the second printed circuit board.

According to an embodiment, the first printed circuit board may include at least one through-hole (e.g., at least one through-hole 422 of FIG. 4B and FIG. 4C) penetrating the first printed circuit board. According to an embodiment, the shielding member may include at least one protrusion (e.g., at least one protrusion 482 of FIG. 4B and FIG. 4D) inserted into the at least one through-hole.

According to an embodiment, since the shielding member and the first printed circuit board are physically coupled to each other by at least one protrusion inserted into at least one through-hole, the electronic device may provide a structure capable of stably maintaining the coupling between the first connector and the second connector.

According to an embodiment, the supporting member may include a conductive part (e.g., the first conductive part 411 of FIG. 4A) surrounding at least part of the electronic component and exposed to outside of the electronic device. According to an embodiment, the electronic device may include a wireless communication circuit electrically connected to the conductive part. According to an embodiment, the wireless communication circuit may be configured to communicate with an external electronic device on a designated frequency band through the conductive part.

According to an embodiment, the electronic device may provide a structure in which an electronic component adjacent to the first conductive part performing a function of an antenna radiator may stably operate by the shielding member overlapping (e.g. partially) the first printed circuit board, and/or covering at least part of the second printed circuit board.

According to an embodiment, the first printed circuit board may include a plurality of contacts (e.g., the plurality of contacts 423 of FIG. 5A and FIG. 5B) disposed on the surface of the first printed circuit board and surrounding the at least part of the second connector. According to an embodiment, the plurality of contacts may be electrically connected to a conductive material of the supporting member.

According to an embodiment, the electronic device may provide a structure that reduces the transmission of the electromagnetic wave to the first printed circuit board and the second printed circuit board by a plurality of contacts surrounding at least a part of the first part.

According to an embodiment, the first printed circuit board may include a contact (e.g., the third contact 423c of FIG. 6C) disposed on the surface of the first printed circuit board and electrically connected to the ground and a conductive material of the supporting member. According to an embodiment, the first printed circuit board may include another contact disposed on another surface (e.g., the fifth contact 423f of FIG. 6C) of the first printed circuit board opposite to the surface of the first printed circuit and electrically connected to the contact. According to an embodiment, the electronic device may include an antenna module (e.g., the antenna module 490 of FIG. 6C) disposed on the other surface of the first printed circuit board and including a conductive material (e.g., the conductive material 491 of FIG. 6C) electrically connected to the other contact.

According to an embodiment, since a part of the antenna module is electrically connected to the second conductive part providing an electrical ground, the electronic device may provide a structure that reduces the transmission of the electromagnetic wave to the first printed circuit board and the second printed circuit board.

According to an embodiment, the first printed circuit board may include a conductive via (e.g., the first conductive via 424 of FIG. 6C) penetrating at least part of the first printed circuit board to electrically connect the contact and the other contact.

According to an embodiment, the electronic device may provide a structure that reduces the transmission of the electromagnetic wave to the first printed circuit board and the second printed circuit board by a conductive via connecting the third contact and the fifth contact.

According to an embodiment, the conductive material may be disposed to a surface of the antenna module facing the other surface of the first printed circuit board. According to an embodiment, the antenna module may include a ground pattern (e.g., the ground pattern 493 of FIG. 6C) disposed on another surface of the antenna module opposite the surface of the antenna module. According to an embodiment, the antenna module may include a conductive via (e.g., the second conductive via 492 of FIG. 6C) penetrating at least part of the antenna module to electrically connect the ground pattern and the conductive material. According to an embodiment, the ground pattern may surround at least part of the first part.

According to an embodiment, the electronic device may provide a structure that reduces the transmission of the electromagnetic wave to the first printed circuit board and the second printed circuit board by the ground pattern formed in the antenna module.

According to an embodiment, the electronic component may include an image sensor (e.g., the image sensor 461 of FIG. 4B) configured to obtain an image based on receiving light from the outside of the electronic device.

According to an embodiment, the electronic device may provide a structure for smooth operation of a camera adjacent to the first conductive part that operates as an antenna radiator, by the shielding member overlapping (e.g. partially) the first printed circuit board, and/or covering at least part of the second printed circuit board.

According to an embodiment, a height of the shield wall may correspond to a distance between the surface of the first printed circuit board and the surface of the supporting member.

According to an embodiment, since the height of the shield wall corresponds to the distance between the surface of the supporting member and the surface of the first printed circuit board, the electronic device may provide a structure that reduces the transmission of the electromagnetic wave to the first printed circuit board and the second printed circuit board.

An electronic device (e.g., the electronic device 200 of FIG. 2) is provided. According to an embodiment, the electronic device may comprise a supporting member (e.g., the supporting member 410 of FIGS. 4A, 4B, and 4C) including a conductive part (e.g., the first conductive part 411 of FIG. 4A) exposed to the outside of the electronic device. According to an embodiment, the electronic device may comprise a first printed circuit board (e.g., the first printed circuit board 420 of FIGS. 4A, 4B, and 4D) including a surface (e.g., the surface 420a of FIG. 4A and FIG. 4B) facing the supporting member and disposed in the supporting member. According to an embodiment, the electronic device may comprise a first connector (e.g., the first connector 430 of FIG. 4A, FIG. 4B, and FIG. 4C) disposed on the surface of the first printed circuit board. According to an embodiment, the electronic device may comprise a second printed circuit board (e.g., the third printed circuit board 440 of FIG. 4B and FIG. 4C) including a first part (e.g., the first part 441 of FIG. 4B and FIG. 4C) disposed between the first printed circuit board and the supporting member, a second part (e.g., the second part 412 of FIG. 4B) spaced apart from the first part, and a third part (e.g., the third part 413 of FIG. 4B and FIG. 4C) extending from the first part to the second part and having flexibility. According to an embodiment, the electronic device may comprise a second connector (e.g., the second connector 450 of FIG. 4B and FIG. 4C) coupled to the first connector and disposed on the first part. According to an embodiment, the electronic device may comprise an electronic component (e.g., the electronic component 460 of FIGS. 4A, 4B, 4C, and 4D) disposed on the second part, spaced apart from the first printed circuit board along a direction in which a side surface (e.g., the first side surface 441d of FIG. 4B) of the first part connected to the third part faces, and at least partially surrounded by the conductive part. According to an embodiment, the electronic device may comprise a wireless communication circuit electrically connected to the conductive part and configured to communicate on a designated frequency band through the conductive part. According to an embodiment, the electronic device may comprise a shield wall (e.g., the shield wall 470 of FIG. 4B and FIG. 4C) protruding from a surface of the supporting member facing the first printed circuit board and surrounding at least part of the first part. According to an embodiment, the electronic device may comprise a shielding member (e.g., the shielding member 480 of FIGS. 4A, 4B, 4C, and 4D) covering at least part of the electronic member. According to an embodiment, a part (e.g., the part 481 of FIG. 4A, FIG. 4B, FIG. 4C, and FIG. 4D) of the shielding member overlaps the first printed circuit board, and may cover at least part of the second printed circuit board.

According to an embodiment, the part of the shielding member covers a gap disposed between the shielding member (and/or electronic component 460) and a side surface (e.g., the side surface 420c of FIG. 4B) of the first printed circuit board, for example a side surface that is perpendicular to the surface of the first printed circuit board.

According to an embodiment, the electronic device may provide a structure that reduces the transmission of the electromagnetic wave to the first printed circuit board and the second printed circuit board by a shielding member covering at least a part of a gap between the first printed circuit board and the shielding member (and/or electronic component 460).

According to an embodiment, the part of the shielding member may be electrically connected to a ground layer of the first printed circuit board by being in contact with the first printed circuit board.

According to an embodiment, the electronic device may provide a structure that reduces the transmission of the electromagnetic wave to the first printed circuit board and the second printed circuit board by a shielding member electrically connected to the ground of the first printed circuit board.

According to an embodiment, the first printed circuit board may include at least one through-hole (e.g., at least one through-hole 422 of FIG. 4B and FIG. 4C) penetrating the first printed circuit board. According to an embodiment, the shielding member may include at least one protrusion (e.g., at least one protrusion 482 of FIG. 4B and FIG. 4D) inserted into the at least one through-hole.

According to an embodiment, since the shielding member and the first printed circuit board are physically coupled to each other by at least one protrusion inserted into at least one through-hole, the electronic device may provide a structure capable of stably maintaining the coupling between the first connector and the second connector.

According to an embodiment, the first printed circuit board may include a plurality of contacts (e.g., the plurality of contacts 423 of FIG. 5A and FIG. 5B) disposed on the surface of the first printed circuit board and surrounding the at least part of the second connector. According to an embodiment, the plurality of contacts may be electrically connected to a conductive material of the supporting member.

According to an embodiment, the electronic device may provide a structure that reduces the transmission of the electromagnetic wave to the first printed circuit board and the second printed circuit board by a plurality of contacts surrounding at least a part of the first part.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200) comprising:
a supporting member (410);
an electronic component (460) disposed in the supporting member;
a first printed circuit board (420) including a surface (420a) facing the supporting member;
a first connector (430) disposed on the surface of the first printed circuit board;
a second printed circuit board (440) including a first part (441) disposed between the first printed circuit board and the supporting member, a second part (442) on which the electronic component is disposed, and a third part (443) extending from the first part to the second part;
a second connector (450) coupled to the first connector and disposed on the first part;
a shield wall (470) protruding from a surface (410a) of the supporting member facing the first printed circuit board and surrounding at least part of the first part (441), at least part of the shield wall including conductive material; and
a shielding member (480) covering at least part of the electronic component,
wherein a part (481) of the shielding member (480) overlaps the first printed circuit board (420).

2. The electronic device of claim 1,
wherein the part (481) of the shielding member (480) covers a gap disposed between the shielding member and a side surface (420c) of the first printed circuit board perpendicular to the surface of the first printed circuit board.

3. The electronic device according to any one of claims 1 to 2,
wherein the second part is disposed outside of the first printed circuit board by being spaced apart from the first part along a direction in which the side surface of the first part connected to the third part faces.

4. The electronic device according to any one of claims 1 to 3,
wherein the part of the shielding member (480) is disposed on another surface of the printed circuit board opposite to the surface of the first printed circuit board.

5. The electronic device according to any one of claims 1 to 4,
wherein the part of the shielding member (480) is electrically connected to a ground layer of the first printed circuit board by being in contact with the first printed circuit board.

6. The electronic device of claim 5,
wherein the first printed circuit board (420) further includes a conductive region (421) electrically connected to the ground layer of the first printed circuit board and exposed to the another surface of the first printed circuit board opposite to the surface of the first printed circuit board, and
wherein the part of the shielding member (480) includes a conductive material electrically connected to the ground layer of the first printed circuit board by being in contact with the conductive region.

7. The electronic device according to any one of claims 1 to 6,
wherein the shielding member (480) includes a conductive material electrically connected a ground layer of the second part.

8. The electronic device according to any one of claims 1 to 7,
wherein the first printed circuit board (420) further includes at least one through-hole penetrating the first printed circuit board, and
wherein the shielding member (480) further includes at least one protrusion inserted into the at least one through-hole.

9. The electronic device according to any one of claims 1 to 8, Wherein the supporting member (410) includes a conductive part (411) surrounding at least part of the electronic component and exposed to outside of the electronic device,
wherein the electronic device further includes a wireless communication circuit electrically connected to the conductive part, and
wherein the wireless communication circuit is configured to communicate with an external electronic device on a designated frequency band through the conductive part.

10. The electronic device according to any one of claims 1 to 9,
wherein the first printed circuit board (420) further includes a plurality of contacts (423) disposed on the surface of the first printed circuit board and surrounding the at least part of the second connector, and
wherein the plurality of contacts (423) is electrically connected to a conductive material of the supporting member.

11. The electronic device according to any one of claims 1 to 10,
wherein the first printed circuit board further includes:
a contact (423c) disposed on the surface (420a) of the first printed circuit board and electrically connected to the ground and a conductive material of the supporting member; and
another contact (423f) disposed on another surface (420b) of the first printed circuit board opposite to the surface (420a) of the first printed circuit and electrically connected to the contact, and
wherein the electronic device further includes an antenna module (490) disposed on the another surface (420b) of the first printed circuit board and including a conductive material (491) electrically connected to the another contact (423f).

12. The electronic device of claim 11,
wherein the first printed circuit board (420) further includes a conductive via (424) penetrating at least part of the first printed circuit board to electrically connect the contact (423c) and the another contact (423f).

13. The electronic device of claim 11,
wherein the conductive material is disposed to a surface (490a) of the antenna module facing the another surface (420b) of the first printed circuit board,
wherein the antenna module (490) further includes:
a ground pattern (493) disposed on another surface (490b) of the antenna module opposite the surface of the antenna module; and
a conductive via (492) penetrating at least part of the antenna module to electrically connect the ground pattern and the conductive material, and
wherein the ground pattern surrounds at least part of the first part.

14. The electronic device according to any one of claims 1 to 13,
wherein the electronic component (460) includes an image sensor configured to obtain an image based on receiving light from the outside of the electronic device.

15. The electronic device according to any one of claims 1 to 14,
wherein a height of the shield wall (470) corresponds to a distance between the surface of the first printed circuit board and the surface of the supporting member.
